(19) Europäisches Patentamt
European Patent Office
Office européen des brevets

(11) Publication number: **0 063 216**
**B1**

(12) # EUROPEAN PATENT SPECIFICATION

(45) Date of publication of patent specification: **10.12.86**

(51) Int. Cl.$^4$: **G 11 C 8/00**

(21) Application number: **82101179.8**

(22) Date of filing: **17.02.82**

(54) **Driver Circuit.**

(30) Priority: **16.04.81 US 254806**

(43) Date of publication of application:
**27.10.82 Bulletin 82/43**

(45) Publication of the grant of the patent:
**10.12.86 Bulletin 86/50**

(84) Designated Contracting States:
**DE FR GB**

(56) References cited:
**US-A-4 071 783**

**IBM TECHNICAL DISCLOSURE BULLETIN, vol. 18, no. 12, May 1976, pages 3955-3956, New York, USA**
**G. H. PARIKH: "High-speed fet decoder"**

(73) Proprietor: **International Business Machines Corporation**
**Old Orchard Road**
**Armonk, N.Y. 10504 (US)**

(72) Inventor: **Chappell, Barbara Alane**
**RFD Adele Court**
**Amawalk New York 10501 (US)**
Inventor: **Schuster, Stanley Everett**
**Richard Somers Road**
**Granite Springs New York 10527 (US)**

(74) Representative: **Gasslander, Sten**
**IBM Svenska AB Box 962**
**S-181 09 Lidingö (SE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

**EP 0 063 216 B1**

Courier Press, Leamington Spa, England.

**Description**

This invention relates to driver circuits, such as are particularly suitable for large scale integrated (LSI) circuit technology.

There is a growing need for high performance FET driver circuits which are well suited for LSI applications. This need is particularly acute in an FET type static random access memory (RAM) design where very high speed access is the main object. There are quite a few considerations which contribute to driver circuit performance. The allowable allocated power to which a driver circuit is limited is an important consideration. However, there is generally little control over this factor since the maximum power dissipation of an LSI chip is limited and such power must be allocated to many circuits contained thereon. Aside from the power design consideration, the high performance characteristics of a driver circuit also depend on the size of its input and output capacitative loads. The particular driver circuit configuration and design, of course, contributes appreciably to its performance. For a given power design and load conditions, it requires no small effort to create a novel configuration which produces optimum performance characteristics.

Conventional FET driver circuits employing both enhancement and depletion modes FET devices in a push-pull configuration are well known. An example of such a driver circuit is described in U.S. 3,775,793. In addition, both U.S. 4,065,678 and U.S. 4,071,783 disclose high speed FET driver circuits employing a push-pull circuit and feedback techniques for driving high capacitative loads.

Some prior driver circuits employ FET devices having different thresholds to increase the performance of the driver circuits. For instance, U.S. 4,135,102 describes a high performance driver circuit using FET devices having varying threshold voltage produced by selectively varying ion implantation doses in the channels of the FET devices and using a low threshold depletion mode FET device, rather than a conventional depletion mode FET device, in the output stage. The use of a similar driver circuit in a high speed static RAM is also described in an article by Takahashi, et al., entitled "High Speed 4K Static RAM Using DSA MOSTs", Proceeding of the 9th Conference on Solid State Devices, Tokyo, 1977; and in the Japanese Journal of Applied Physics, Vol. 17 (1978), 17—1, pp. 71—76.

The article of G.G. Parikh, entitled "High-Speed FET Decoder", IBM Technical Disclosure Bulletin, Vol. 18, No. 12, May 1976, pages 3955—3956, describes a decoder circuit for decoding FET random-access memories. The article teaches the use of a switched transfer means for coupling a signal at an input terminal to an internal node of the decoder circuit.

In a prior article, a new logic configuration is described by Blaser, et al., entitled "FET Logic Configuration", Digest of the ISSCC, 1978, pp. 14—15. According to the article, the new logic configuration utilizes a depletion mode FET device to reduce the logic signal levels so asto improve the speed power performance characteristics of conventional logic circuits.

None of the above-described driver circuits is designed and optimized specifically to provide high speed operations in an environment wherein both the input and output capacitances are large. There is no teaching of a driver circuit configuration including a push-pull output circuit in combination with a switched transfer depletion mode FET device adapted to decouple the large input capacitative load from an internal node of the driver circuit, whereby the internal node potential can be raised rapidly, and the bootstrapping effectiveness at the internal node can be enhanced so as to significantly increase the circuit operating speed in driving large output capacitative load.

This invention seeks to provide an improved FET driver circuit which is capable of high speed operation in an environment wherein both large input and output capacitative loads are present.

This invention also seeks to provide an improved FET driver circuit which is capable of making high speed transition from a low logic level to a high logic level.

This invention also seeks to provide an improved FET driver circuit which provide a full VDD high logic level output.

This invention also seeks to provide an improved FET driver circuit which can be powered down during an inactive cycle to minimize power dissipation.

This invention also seeks to provide an improved FET driver for static RAM to enhance the access speed of such memory.

The scope of the present invention is defined by the appended claims: and how it can be carried into effect is hereinafter particularly described with reference to the accompanying drawings, in which:—

FIG. 1 is a schematic illustration of a high performance FET driver circuit according to the present invention, with a decoder providing an input;

FIG. 2 illustrates the operation of the circuit of FIG. 1 driving a word line from a low logic level to a high logic level; and

FIG. 3 characterizes driver circuit speed performance as a function of output capacitative load, with input capacitative load of the same size.

Referring to FIG. 1, a word decoder 10 in a static FET RAM is connected to a high performance driver 20 by way of a line 60 to select a word line 50. The equivalent capacitances of word line 50 and line 60 are represented by capacitors 52 and 62, respectively. Both capacitors 52 and 62 have capacitances which are comparatively large relative to the average nodal capacitance of an LSI circuit chip. The interconnections of word decoder 10, line 60, driver 20, and word line 50 form a critical path. The propagation delay of this critical path, among other factors, substantially determines the access speed of the static FET RAM.

The decoder 10 includes a plurality of decoder devices D1, D2, . . ., DN, each connected, as shown, to an associated line of a plurality of address lines A1, A2, . . ., AN.

The high performance driver 20 is preferably fabricated in an N-channel FET technology, in which both enhancement mode and depletion mode FET devices, as well as zero threshold FET devices are constructed on a single silicon wafer.

According to the present invention, driver 20 includes a push-pull circuit 30, an inverter circuit 40, a load circuit 25, and a switched transfer FET device 27. Driver 20 is of the non-inverting type, i.e., its input state is the same as its output state. More specifically, driver 20 features a large output drive capability, and is particularly effective in reducing critical path propagation delay in a circuit environment in which both the input and the output capacitances are comparatively large.

Switched transfer FET device 27 couples a digital input signal present on line 60, from an input terminal 22 to an internal node 80 of driver 20. The load circuit 25 includes FET devices 26 and 28 and couples a first voltage source VDD to the internal node 80. The inverter circuit 40, includes FET devices 42 and 44 and is connected to the voltage source VDD and ground, a second voltage source. An input 46 of inverter circuit 40 is connected to the internal node 80 and its output 48 is connected to the gate 29 of switched transfer FET device 27. Push-pull circuit 30 includes FET devices 32 and 34 and is connected to the voltage source VDD and to ground. A second input 38 of the push-pull circuit 30 is connected to the output 48 of the inverter circuit 40, and a first input 36 of push-pull circuit 30 is connected to the internal node 80 for manifesting the digital signal at an output terminal 39.

The FET devices of driver 20 are made selectively of either the enhancement mode, or depletion mode or zero threshold type. In particular, FET devices 27, 28 and 42 are depletion mode type, FET devices 26 and 32 are zero threshold type, and FET devices 34 and 44 are enhancement mode type. The novel aspect of this new driver circuit 20 configuration can best be understood from the following description of a complete cycle operation.

As an example of a complete cycle operation, consider the case in which the decoder devices D1 to DN of decoder 10 have been off. A2, one of the address lines A1 to AN, goes high and turns on its associated decoder device D2 causing line 60, input terminal 22, and internal node 80 to go low. This, in turn, will cause FET device 44 of inverter 40 to turn off and inverter output 48 to go high clamping the word line 50 low by way of FET device 34. In addition, the inverter output 48 rising will switch the transfer FET device 27 to a low impedance state. Because the current from load circuit 25 flows through the switched transfer FET device 27 when one of the decoder devices is on, reducing the impedance of the switched transfer FET device 27 has a significant effect, because its lowers the potential at internal node 80 and thus prevents the output line 50 from rising by allowing FET device 32 to turn off. The impedance of switched transfer FET device 27 is reduced by a significant factor (approximately 10) as compared to the case where the transfer gate 29 is tied to a fixed ground potential as in the conventional circuit described by Blaser. This reduction in impedance tends to discharge quickly the internal node 80 and substantially improves the high to low transition delay.

Next, consider the case in which all the address lines go low turning the decoder devices off. Input terminal 22 and the internal node 80 will start to rise. The switched transfer FET device 27 will remain in the low impedance state during the initial part of this transient, because the inverter output 48 is still high. However, as internal node 80 continues to rise, inverter output 48 will fall, putting the switched transfer FET device 27 into a high impedance state. Input terminal 22 will rise to a potential which is one threshold voltage below the gate potential of the switched transfer FET device 27, and then it turns off. When this occurs, the large capacitance associated with line 60 as represented by capacitor 62 is effectively decoupled from the internalnode 80. As a result, the entire load current of load circuit 25 now goes into charging internal node 80. Push-pull operation is achieved as internal node 80 rises and turns on FET device 32, thus charging the large capacitance associated with word line 50 and represented by capacitor 52, and FET device 34 of the push-pull circuit 30 is turned off by the low voltage at the inverter output 48. Stated in another way, the switched transfer FET device 27 switches off during the initial phase of the low to high transition, decoupling the relatively large capacitor 62 from the internal node 80. This decoupling charges capacitor 62 only to an intermediate voltage level below VDD and enables the entire load current to charge up a small (as compared to the size of capacitor 62) nodal capacitance, represented by capacitor 56, rapidly. This rapid potential build up at internal node 80 together with the push-pull mode operation significantly improves the low to high transition delay. Detailed operation is described hereinafter in relation to FIG. 2.

Decoupling the internal node 80 from line 60 and its associated large capacitance represented by capacitor 62, also enhances the effectiveness of the gate to source bootstrapping of FET device 32 by way of a gate to source capacitor 54. More specifically, the decoupling allows the bootstrapping effectiveness to be determined by the capacitance of capacitor 56 alone and not by the parallel combination of the capacitances of capacitors 56 and 62. Because the capacitance of capacitor 56 is relatively small compared to the capacitance of capacitor 62, the bootstrap enhancement is substantial. In addition, capacitor 51 may also be incorporated to provide bootstrapping effectiveness by coupling the positive going transient present at the word line 50 to the internal node 80 by way of FET device 28. These bootstrap enhancements in combination tend to drive FET device 32 harder, and further improves the low to high transition delay as well as providing a full VDD high logic level.

The operation of the high performance driver 20 driving a selected word line 50 from a low to a high logic level is specifically illustrated in FIG. 2. VA, the potential of every address line, goes low to permit both V22, the potential of the input terminal 22 and V80, the internal node 80 potential, to rise during the initial phase of this transition. The fall of V48, the output voltage of inverter circuit 40, in response to VA puts the switched transfer FET device 27 in a high impedance state from an initial low impedance state. This latter action decouples the relatively large capacitance of capacitor 62 from the internal node 80. As a result, V22 rises only to about 2.6 volts, an intermediate potential below VDD (5 volts) while V80 is allowed to charge up to VDD and beyond because of the above-described bootstrapping enhancements. The combined improvements as a result of decoupling the large capacitance of the capacitor 62, and the increased bootstrapping effectiveness permit V0, the output node potential to rise rapidly in spite of the relatively large capacitance of the capacitor 52.

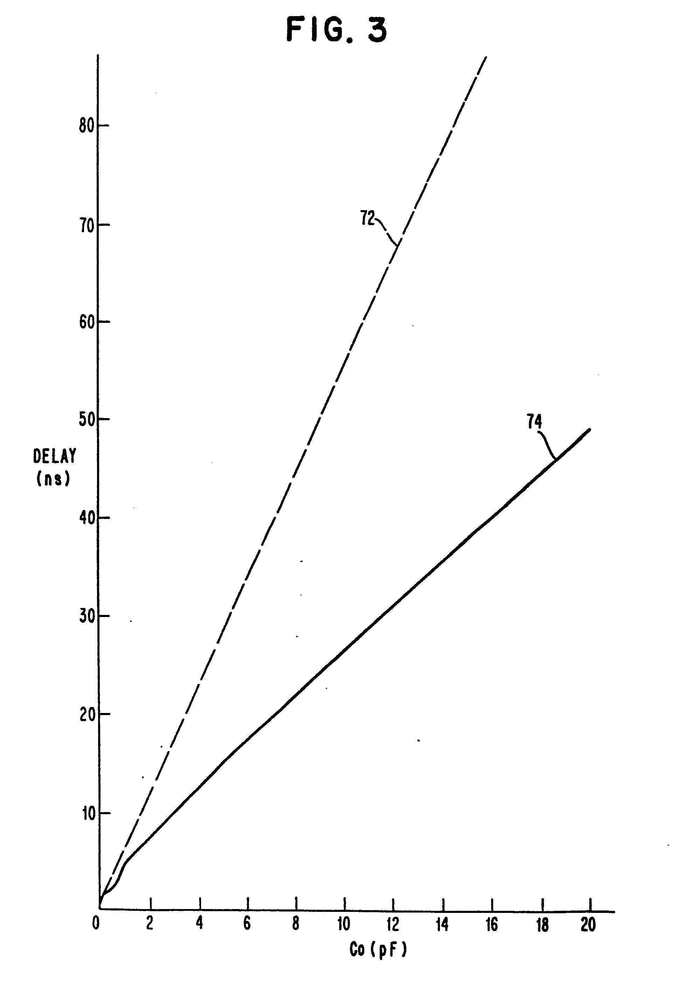

The improvement made possible by the use of this new driver configuration is illustrated in FIG. 3. Curve 74 illustrates the performance characteristics of a driver circuit according to the present invention. Curve 72 illustrates the performance characteristics of a similar conventional non-inverting push-pull driver circuit operating at the same power level. For equal size input and output capacitors 62 and 52, the performance improvement in circuit delay is significant. For example, with both capacitors 52 and 62 having a value of 10 pF, driver 20 according to the present invention has a transition delay of about 28 nanoseconds (curve 74 in FIG. 3), which is about twice the performance of a similar conventional non-inverting push-pull driver of identical power dissipation having a corresponding transition delay of about 60 nanoseconds (curve 72 in FIG. 3).

Referring again to FIG. 1, it should be noted that load circuit 25 comprising the series combination of the depletion FET device 28 and the zero threshold FET device 26 can be selectively powered off to minimize power consumption. More particularly, the gate of the FET device 26 may be clocked by $\phi_c$ to minimize power during that portion of a cycle that the associated decoder is not active. In addition it should be noted that as node 80 attempts to bootstrap above VDD, FET device 26 turns off, facilitating V80, the potential at node 80, to rise higher than VDD as shown by curve V80 in FIG. 2.

While inverter circuit 40 and push-pull circuit 30 are both described in the preferred embodiment above as separate and distinct circuits, the two circuits actually form a conventional non-inverting push-pull driver with inverter circuit 40 as the first stage and circuit 30 as the second output stage. It may be helpful to view them as such in understanding and appreciating the present invention, especially for one skilled in this art.

Although the high performance FET driver 20 is shown in FIG. 1 and described as incorporating zero threshold FET devices 26 and 32, driver operation is basically the same and the same substantial advantages can still be realized, when driver 20 is fabricated in a technology wherein only standard depletion and enhancement mode FET devices are available. In addition, although load circuit 25 is shown to be clocked and to include a series combination of depletion mode FET device 28 and the zero threshold FET device 26 to minimize power, it is clear that the gate of FET device 26 need not be clocked, and instead may be connected to VDD. Furthermore, the load circuit may be substituted with a standard depletion FET device load without substantial loss of the aforesaid performance advantages.

Although the above-described preferred embodiment of the present invention is shown and described in a static RAM environment, the above-described performance advantages can be realized generally in any situation wherein both large input and output capacitative loads are present. For example, driver 20 according to the present invention may be used advantageously for driving off-chip and inter-block large capacitative loads in situations where the input capacitative loads are high.

**Claims**

1. A driver circuit comprising a switched transfer means (27) coupling a signal at an input terminal (22) to an internal node (80) of said driver circuit (20), a load (25) coupling a first voltage source (VDD) to said internal node (80) for charging said internal node (80), and a push-pull circuit (30, 40) having a first stage (40), a second (30) stage, an output (39), and an input (36) connected to the internal node for manifesting the signal to the output terminal, connected between said first voltage source (VDD) and a second voltage source, characterized in that the input (46) of said first stage (40) is connected to said internal node (80), and the output of said first stage (40) is coupled to said switched transfer means (27), the switched transfer means (27) being placed in a first state to provide a low impedance coupling between said internal node (80) and said input terminal (22) when the output of said first stage (40) is at a high logical level, and the switched transfer means (27) being placed in high impedance second state to provide an insolation of said internal node (80) from the input terminal (22) when the output of said first stage (40) shifts from the high logical level to a low logic level, whereby the load (25) charges said internal node (80) to a high potential and charges said input terminal (22) to an intermediate potential below the high potential of the internal node.

2. A driver circuit according to Claim 1, in which the switched transfer means is a depletion mode FET device (27).

3. A driver circuit according to Claim 1 or 2, in which the first stage (40) is an inverter having the inverter input (46) connected to the internal node.

4. A driver circuit according to Claim 1, 2 or 3, in which the second stage comprises a first FET device (32) coupling the first voltage source to the output terminal (39), the gate of the first FET device being connected to the internal node, and a second FET device (34) coupling the output terminal (39) to the second voltage source, the gate of the second FET device being connected to the output of the first stage.

5. A driver circuit according to Claim 4, in which the first FET device is a zero threshold FET device, and the second FET device is an enhancement mode FET device.

6. A driver circuit according to any preceding claim, in which the load comprises a third FET device (26) coupling the first voltage source to a feedback node, the gate of third FET device being connectable to a voltage source, and a fourth FET (28) coupling the feedback node to the internal node, the gate of the fourth FET device being connected to the internal node.

7. A driver circuit according to Claim 6, in which the third FET device is a zero threshold FET device, and the gate of the third FET device is connected to a control clock, whereby the load may be turned off to minimize power.

8. A driver circuit according to Claim 6 or 7, in which the fourth FET device is a depletion mode FET device.

9. A driver circuit according to Claim 6, 7 or 8, including a bootstrap capacitor (51) coupling a positive-going transient present at the output terminal (39) to the internal node (80) by way of the feedback node.

10. A driver circuit according to any preceding claim, including a bootstrap capacitor (54) coupling the output terminal (39) to the internal node (80).

**Patentansprüche**

1. Treiberschaltung, welche geschaltete Transfermittel (27), welche ein Signal an einem Eingangsanschluß (22) auf einen internen Knoten (80) der Treiberschaltung (20) koppeln, eine Last (25), welche eine erste Spannungsquelle (VDD) auf den internen Knoten (80) zur Aufladung des internen Knotens (80) koppelt, und eine Gegentaktschaltung (30, 40) mit einer ersten Stufe (40), einer zweiten Stufe (30), einem Ausgang (39) und einem mit dem internen Knoten verbundenen Eingang (36) zum Erscheinenlassen des Signals am Ausgangsanschluß, welche zwischen der ersten Spannungsquelle (VDD) und einer zweiten Spannungsquelle angeschlossen ist, aufweist, dadurch gekennzeichnet, daß der Eingang (46) der ersten Stufe (40) mit dem internen Knoten (80) verbunden ist und der Ausgang der ersten Stufe (40) auf die geschalteten Transfermittel (27) gekoppelt ist, wobei die geschalteten Transfermittel (27) in einen ersten Zustand zur Schaffung einer niederohmigen Kopplung zwischen dem internen Knoten (80) und dem Eingangsanschluß (22) gesetzt werden, wenn sich der Ausgang der ersten Stufe (40) auf hohem logischen Pegel befindet, und die geschalteten Transfermittel (27) in einen hochohmigen zweiten Zustand zur Schaffung einer Isolation des internen Knotens (80) vom Eingangsanschluß (22) gesetzt werden, wenn der Ausgang der ersten Stufe (40) von dem hohen logischen Pegel auf einen niedrigen logischen Pegel übergeht, wodurch die Last (25) den internen Knoten (80) auf ein hohes Potential und den Eingangsanschluß (22) auf ein dazwischen liegendes Potential unter dem hohen Potential des internen Knotens auflädt.

2. Treiberschaltung nach Anspruch 1, bei welcher die geschalteten Transfermittel eine Entleerungstyp-FET-Vorrichtung (27) sind.

3. Treiberschaltung nach Anspruch 1 oder 2, bei welcher die erste Stufe (40) ein Inverter ist, dessen Invertereingang (46) mit dem internen Knoten verbunden ist.

4. Treiberschaltung nach Anspruch 1, 2 oder 3, bei welcher die zweite Stufe eine ersten FET-Vorrichtung (32), welche die erste Spannungsquelle auf den Ausgangsanschluß (39) koppelt, wobei das Gate der ersten FET-Vorrichtung mit dem internen Knoten verbunden ist, und eine zweite FET-Vorrichtung (34), welche den Ausgangsanschluß (39) auf die zweite Spannungsquelle koppelt, wobei das Gate der zweiten FET-Vorrichtung mit dem Ausgang der ersten Stufe verbunden ist, aufweist.

5. Treiberschaltung nach Anspruch 4, bei welcher die erste FET-Vorrichtung eine Null-Schwellen-FET-Vorrichtung und die zweite FET-Vorrichtung eine Anfachungstyp-FET-Vorrichtung ist.

6. Treiberschaltung nach irgendeinem vorstehenden Anspruch, bei welcher die Last eine dritte FET-Vorrichtung (26), welche die erste Spannungsquelle auf einen Rückkopplungsknoten koppelt, wobei das Gate der dritten FET-Vorrichtung mit einer Spannungsquelle verbindbar ist, und eine vierte FET-Vorrichtung (28), welche den Rückkopplungsknoten auf den internen Knoten rückkoppelt, wobei das Gate der vierten FET-Vorrichtung mit dem internen Knoten verbunden ist, aufweist.

7. Treiberschaltung nach Anspruch 6, bei welcher die dritte FET-Vorrichtung eine Null-Schwellen-FET-Vorrichtung ist und das Gate der dritten FET-Vorrichtung mit einem Steuertakt verbunden ist, wodurch zur Minimalisierung der Leistung die Last abgeschaltet werden kann.

8. Treiberschaltung nach Anspruch 6 oder 7, bei welcher die vierte FET-Vorrichtung eine Entleerungstyp-FET-Vorrichtung ist.

9. Treiberschaltung nach Anspruch 6, 7 oder 8, welche einen Bootstrap-Kondensator (51) enthält, welcher einen am Ausgangsanschluß (39) vorhandenen positiv-gehenden Einschwingvorgang über den Rückkopplungsknoten auf den internen Knoten (80) koppelt.

10. Treiberschaltung nach irgendeinem vorstehenden Anspruch, welche einen Bootstrap-Kondensator (54) enthält, welcher den Ausgangsanschluß (39) auf den internen Knoten (80) koppelt.

**Revendications**

1. Circuit formant étage d'attaque comportant des moyens de transfert à commutation (27), transmettant un signal présent sur une borne d'entrée (22) à un noeud intérieur (80) dudit circuit de commande (20), une charge (25) reliant une première source de tension (VDD) audit noeud intérieur (80) pour charger ce noeud intérieur (80), et un circuit push-pull (30, 40) comportant un premier étage (40), un second étage (30), une sortie (39) et une entrée (36) raccordée au noeud intérieur afin de transmettre le signal à la borne de sortie raccordée entre ladite première source de tension (VDD) et une seconde source de tension, caractérisé en ce que l'entrée (46) dudit premier étage (40) est raccordée audit noeud intérieur (80) et que la sortie dudit premier étage (40) est accouplée auxdits moyens de transfert à commutation (27), ces moyens (27) de transfert à commutation étant placés dans un premier état pour réaliser un accouplement à faible impédance entre ledit noeud intérieur (80) et ladite borne d'entrée (22) lorsque la sortie dudit premier étage (40) est à un niveau logique haut, et ces moyens de transfert à commutation (27) étant placés dans un second état d'impédance élevé de manière à réaliser une isolation entre ledit noeud intérieur (80) et la borne d'entrée (22) lorsque la sortie dudit premier étage (40) passe du niveau logique haut à un niveau logique bas, ce qui a pour effet que la charge (25) charge ledit noeud intérieur (80) à un potentiel élevé et charge ladite borne d'entrée (22) à un potentiel intermédiaire inférieur au potentiel élevé du noeud intérieur.

2. Circuit formant étage d'attaque selon la revendication 1, dans lequel des moyens de transfert à commutation sont constitués par un dispositif FET du type à appauvrissement (27).

3. Circuit formant étage d'attaque selon la revendication 1 ou 2, dans lequel le premier étage (40) est un inverseur dont la borne (46) est raccordée au noeud intérieur.

4. Circuit formant étage d'attaque selon la revendication 1, 2 ou 3, dans lequel le second étage comporte un premier dispositif FET (32) accouplant la première source de tension à la borne de sortie (39), la grille du premier dispositif FET étant raccordée au noeud intérieur, et un second dispositif FET (34) accouplant la borne de sortie (39) à la seconde source de tension, la grille du second dispositif FET étant raccordée à la sortie du premier étage.

5. Circuit formant étage d'attaque selon la revendication 4, dans lequel le premier dispositif FET est un dispositif FET à seuil nul et le second dispositif FET est un dispositif FET du type à enrichissement.

6. Circuit formant étage d'attaque selon l'une quelconque des revendications précédentes, dans lequel la charge comporte un troisième dispositif FET (26) accouplant la première source de tension à un noeud de réaction, la grille du troisième dispositif FET pouvant être raccordée à une source de tension, et un quatrième dispositif FET (28) accouplant le noeud de réaction au noeud intérieur, la grille du quatrième dispositif FET étant raccordée au noeud intérieur.

7. Circuit formant étage d'attaque selon la revendication 6, dans lequel le troisième dispositif FET est un dispositif FET à seuil nul, et la grille du troisième dispositif FET est raccordée à une horloge de commande, ce qui a pour effet que la charge peut être débranchée afin de réduire l'énergie.

8. Circuit formant étage d'attaque selon la revendication 6 ou 7, dans lequel le quatrième dispositif FET est un dispositif FET du type à appauvrissement.

9. Circuit formant étage d'attaque selon la revendication 6, 7 ou 8, comprenant un condensateur auto-élévateur (51) transmettant un phénomène transitoire devenant positif, présent sur la borne de sortie (39), au noeud intérieur (80) au moyen du noeud de réaction.

10. Circuit formant étage d'attaque selon l'une quelconque des revendications précédentes, comprenant un condensateur auto-élévateur (54) accouplant la borne de sortie (39) au noeud intérieur (80).

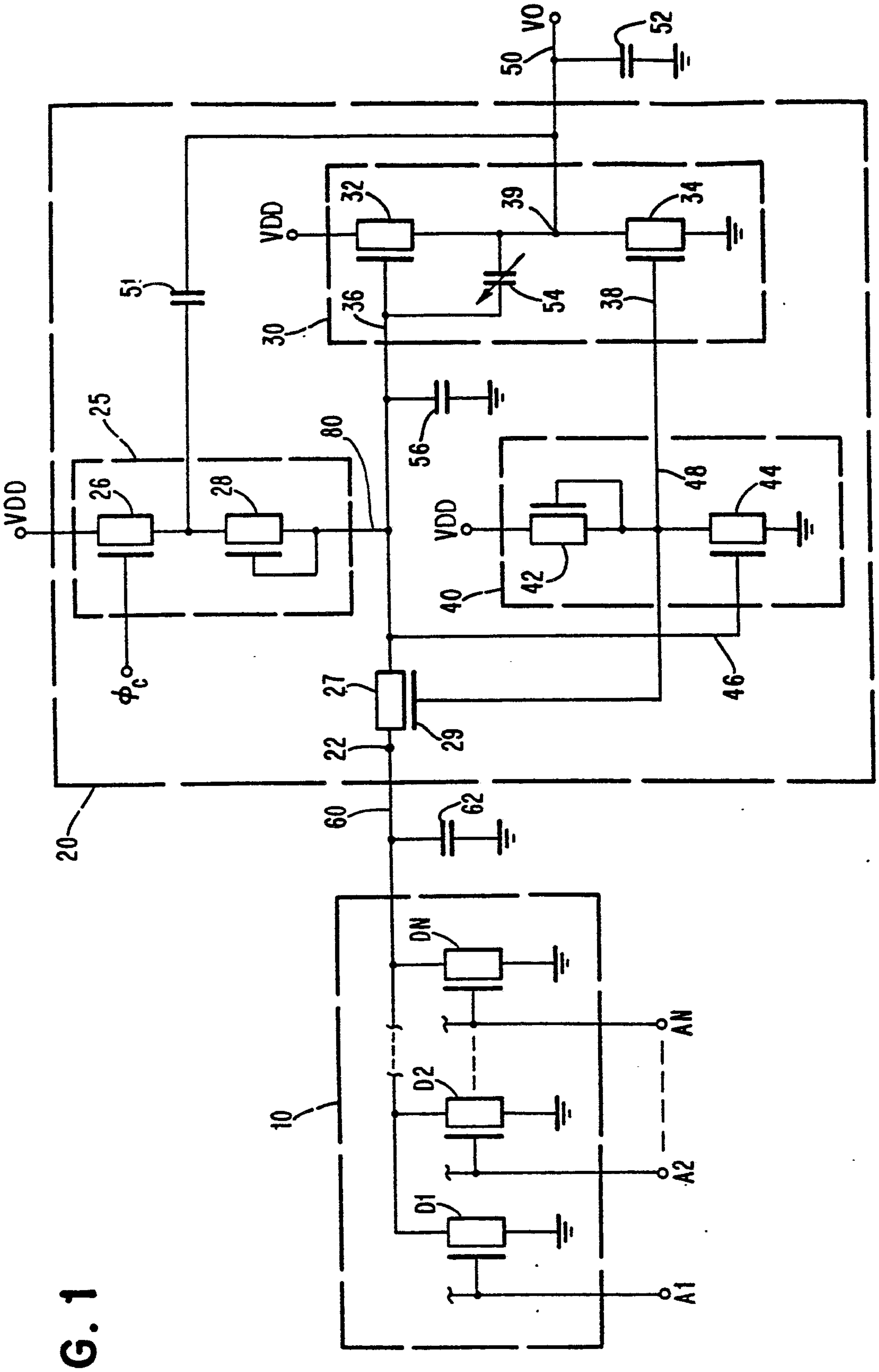
VO
50
52
VDD
32
39
34
51
36
54
38
30
25
VDD
26
28
80
56
48
44
VDD
42
40
46
φc
27
29
22
60
62
20
10
DN
D2
D1
AN
A2
A1

FIG. 1

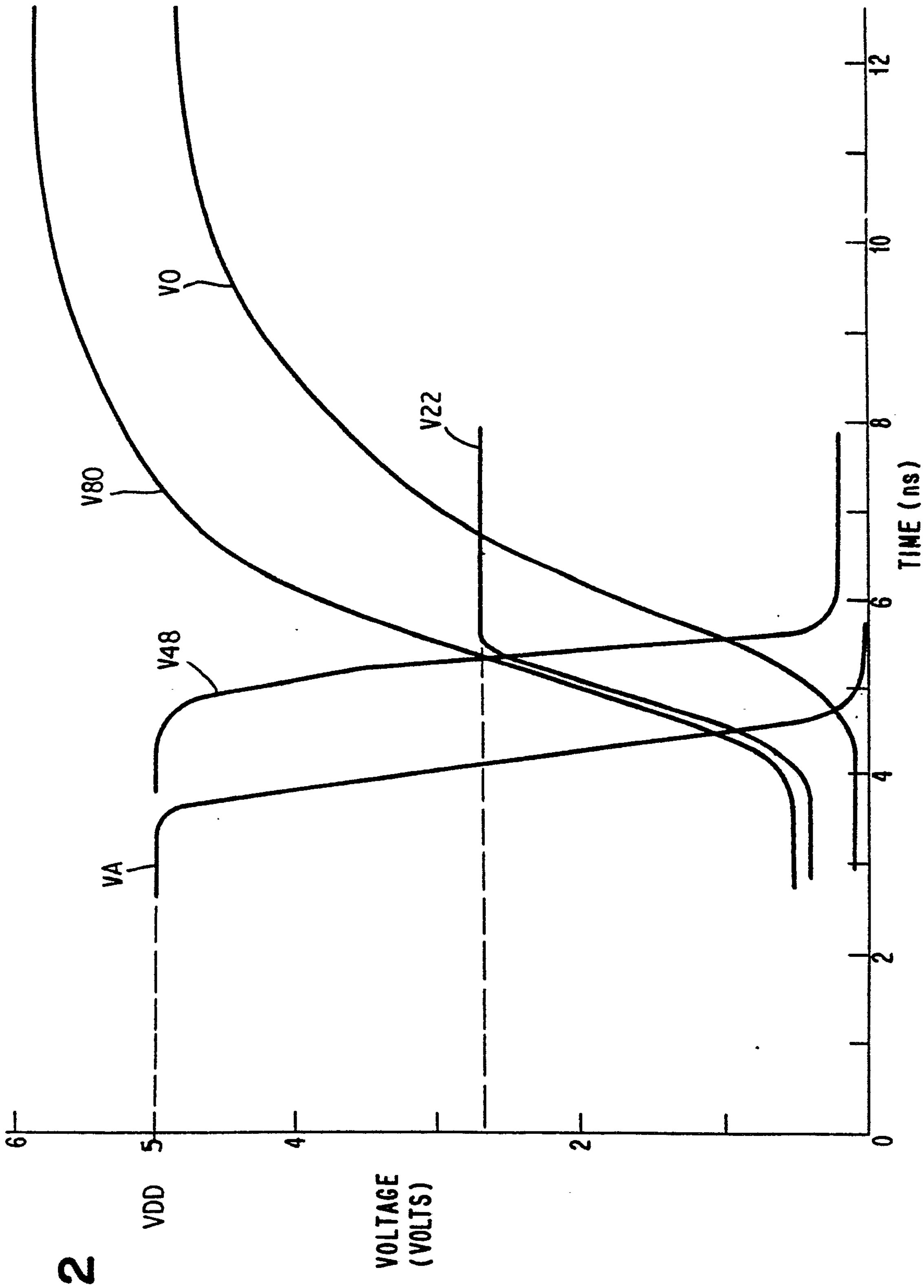


FIG. 2

FIG. 3